(19) Europäisches Patentamt
European Patent Office
Office européen des brevets

(11) **EP 3 154 120 A1**

(12) **EUROPEAN PATENT APPLICATION**

(43) Date of publication:
**12.04.2017 Bulletin 2017/15**

(51) Int Cl.:
**H01M 10/44** *(2006.01)*          **G01R 31/36** *(2006.01)*
**H01M 10/46** *(2006.01)*          **H01M 10/48** *(2006.01)*
**H02J 7/00** *(2006.01)*           **B60L 11/18** *(2006.01)*

(21) Application number: **15465548.4**

(22) Date of filing: **09.10.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **Continental Automotive GmbH
30165 Hannover (DE)**

(72) Inventors:
• **Laiu, Cristian
  300351 Timisoara (RO)**
• **Ivascu, Liviu
  210235 Tirgu Jiu (RO)**
• **Uritescu, Valentin
  307220 Giroc (RO)**
• **Aldea-Ungurean, Doru
  307285 Mosnita Noua (RO)**

(54) **SYSTEM AND METHOD FOR ESTIMATING A TEMPERATURE**

(57)    A method for determining the temperature of a battery comprises determining a dependency of the battery temperature as a function of a second temperature, wherein the second temperature is a temperature distant to the battery (2), measuring the second temperature, and estimating the temperature of the battery (2) according to the determined dependency.

FIG 1

Printed by Jouve, 75001 PARIS (FR)

**Description**

The current invention refers to a system and a method for estimating a temperature, particularly the temperature of a lithium-ion battery.

Rechargeable lithium-ion (li-ion) batteries are used for many different applications, e.g. in consumer and automotive electronics. For example, a li-ion battery may be used for powering a so-called on-board unit. In many countries all over the world there are toll roads (also known as turnpikes or tollways), for which a fee (or toll) is assessed for passage. Different systems for collecting the toll are known, for example electronic road toll systems. In electronic road toll systems an on-board unit is installed in the vehicle to determine the position of the vehicle and transmit position data to a central office for billing.

In li-ion batteries, lithium ions move from a negative electrode to a positive electrode during discharge and from the positive electrode to the negative electrode when charging. Several charging mechanisms and devices are known. In some applications, e.g. automotive applications, temperatures inside a device may rise to 80 °C and more. Such high temperatures may damage the li-ion battery. In some cases this may lead to a reduced battery lifetime, whereas in other applications the batteries may be more severely damaged, e.g. the battery may explode. Charging a li-ion battery should generally be avoided, when the battery temperature rises above 40 °C or falls below 0 °C.

Therefore, the battery temperature needs to be monitored. The easiest way to measure the battery temperature is to place a temperature sensor, e.g. NTC type sensors (NTC = negative temperature coefficient), directly on the battery. This, however, results in higher costs of the battery and a more complex design.

The problem to be solved by the current invention is, therefore, to provide a system and a method for determining the battery temperature at comparatively low costs, using a relatively simple design.

This problem is solved by a method according to claim 1 and a system according to claim 10. Configurations and further developments of the invention are subject of the dependent claims.

A method for determining the temperature of a battery comprises determining a dependency of the battery temperature as a function of a second temperature, wherein the second temperature is a temperature distant to the battery. The method further comprises measuring the second temperature and estimating the temperature of the battery according to the determined dependency.

The dependency of the battery temperature as a function of the second temperature may be determined by determining at least two pairs of values, each pair of values comprising a battery temperature and a corresponding second temperature. By determining the dependency by means of several samples, the dependency is more accurate and reliable.

Determining the dependency of the battery temperature as a function of the second temperature may further comprise modeling the dependency, using a regression method. The regression method may be a polynomial regression model. This allows a quite good estimation of the real temperature.

The second temperature may be a temperature of a charging unit which is coupled to the battery and which is configured to charge the battery. More specific, the second temperature may be an ambient temperature within the charging unit. Alternatively, the second temperature may be a temperature measured on a printed circuit board of the charging unit. It is usually much cheaper to place a temperature sensor within the charging unit than integrating it in the battery.

The method may further comprise to stop or prevent charging the battery, if the estimated battery temperature is below a first temperature threshold or above a second temperature threshold. The first temperature threshold may be 0 °C and the second temperature threshold may be 40 °C. Charging the battery at very low or very high temperatures may lead to a permanent damage of the battery or a reduced life time.

A system for estimating the temperature of a battery comprises a temperature sensor, configured to measure a second temperature, wherein the second temperature is a temperature distant to the battery and a controller, configured to estimate the temperature of the battery according to a predetermined dependency of the battery temperature as a function of the second temperature.

The battery may be a lithium-ion battery.

The system may further comprise a charging unit which is coupled to the battery and which is configured to charge the battery.

The temperature sensor may be coupled to a printed circuit board within the charging unit, and the temperature sensor may be configured to measure the temperature of the printed circuit board.

The temperature sensor may be coupled to a housing of the charging unit, and the temperature sensor may be configured to measure an ambient temperature within the charging unit.

Examples are now explained with reference to the drawings. In the drawings the same reference characters denote like features.

Figure 1 schematically illustrates in a block diagram an example of a battery charging circuit,

Figure 2 schematically illustrates in a block diagram a further example of a battery charging circuit,

Figure 3 schematically illustrates in a diagram different temperatures over an actual battery temperature,

Figure 4 schematically illustrates in a diagram the actual battery temperature over a temperature measured distant to the battery,

Figure 5 schematically illustrates in a diagram estimated battery temperatures and an actual battery temperature,

Figure 6 illustrates an example of a method for estimating a battery temperature according to the present invention,

Figure 7 schematically illustrates a software module for performing a method for estimating a battery temperature according to the present invention, and

Figure 8 illustrates in a sequence diagram the interaction of objects in a software module for performing a method for estimating a battery temperature according to the present invention.

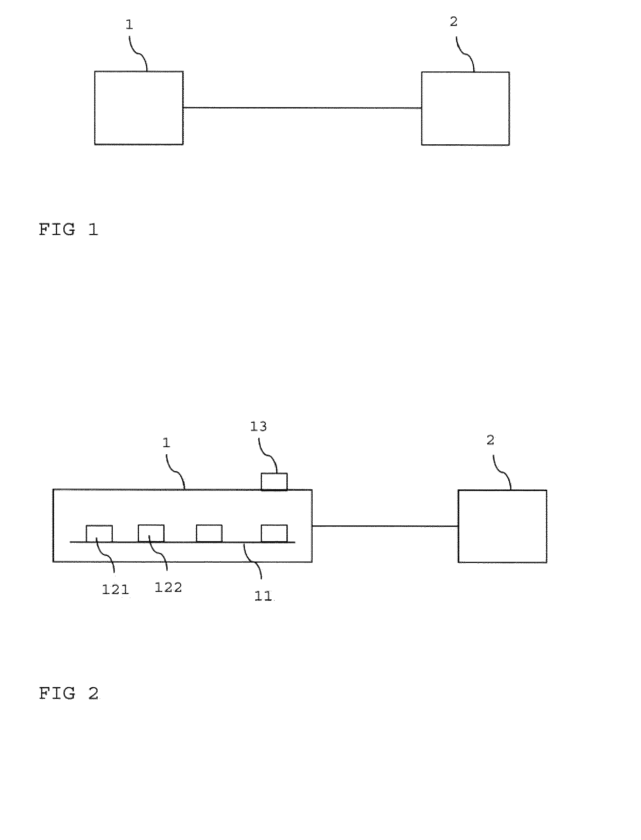

Figure 1 illustrates in a block diagram a battery charging system. The battery charging system includes a charging unit 1 and a chargeable battery 2. The chargeable battery 2 may be a lithium-ion (li-ion) battery, for example. The battery charging system, including the charging unit 1 and the battery 2, may be installed in an on-board unit, for example. An on-board unit is generally installed in a vehicle and is configured to collect position data of the vehicle. The position data is used for billing, when the vehicle is driven on toll roads. Many countries today have so-called toll roads, on which a toll is due for passage. Inside an on-board unit, or any other application, the charging unit 1 may be included in a first housing. The battery 2, however, may not be included in the first housing, but may be coupled to the first housing by means of a cable, for example.

The charging unit 1 may include a printed circuit board (PCB) 11, for example (Figure 2). Several components for implementing the functions of the charging unit 1, like controllers 121, may be mounted on the PCB 11. One of the components may be a temperature sensor 122, for example. As the functionality of many components can only be guaranteed for certain temperatures, it is often necessary to monitor the temperature of the charging unit 1. A temperature sensor 122 may, for example, be mounted on the PCB 11 to measure the PCB temperature. It is, however, also possible to mount a temperature sensor 13 to the housing of the charging unit 1 to measure an ambient temperature.

The temperature of the battery 2 should generally not rise above a certain level. Especially while charging, the battery 2 should not rise above a temperature of about 40 °C, for example. Temperatures of, for example, less than about 0 °C while charging may also lead to substantial damages of the battery 2. Therefore, charging of the battery 2 may be stopped when the battery temperature falls below a first temperature threshold (e.g. 0 °C) or rises above a second temperature threshold (e.g. 40 °C).

One possibility to measure the battery temperature is to place a temperature sensor directly on the battery 2. This is, however, comparatively expensive. Further, more connections need to be provided between the battery 2 and the charging unit 1, to transmit the measurement results to the charging unit 1 for further processing. Instead of measuring the battery temperature directly at the battery 2, the temperature may be measured at the charging unit 1. For example, the PCB temperature of the charging unit 1 or the ambient temperature within a housing of the charging unit 1 may be measured.

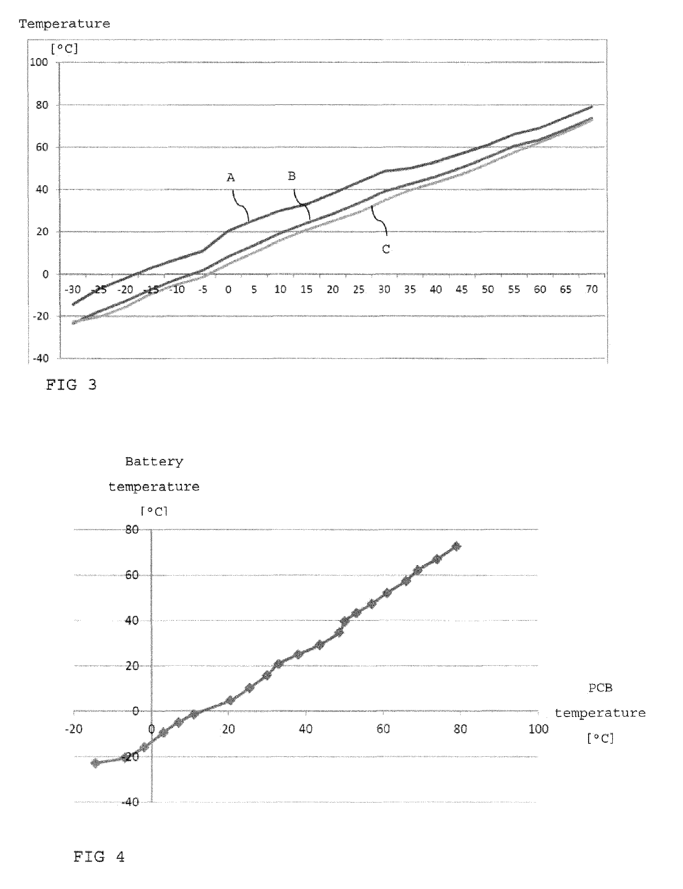

A PCB or ambient temperature at the charging unit 1, however, may defer considerably from the battery temperature, because the battery 2 is mounted distant to the charging unit 1. This is illustrated in the diagram of Figure 3. In the diagram of Figure 3, different temperatures are illustrated over the battery temperature. In a first graph A, the ambient temperature in the charging unit 1 is illustrated over the battery temperature. When the ambient temperature rises to 40 °C, the battery temperature may still only be at about 30 °C, for example. If only the ambient temperature is measured and monitored, charging may be stopped too early, when the ambient temperature crosses the threshold temperature, but the battery voltage is not yet 40 °C. The same applies when measuring the PCB temperature. The PCB temperature over the battery temperature is illustrated in graph B. The PCB temperature may be closer to the battery temperature than the ambient temperature. However, the PCB temperature generally also does not match the battery temperature, as the battery 2 is not mounted on the PCB 11 or close to a temperature sensor 12.

The current invention therefore provides a compensation mechanism to compensate the temperature differences between the measured temperature and the actual battery temperature. The measured temperature may be a PCB temperature of a charging module 1, an ambient temperature of the charging module 1 or any other temperature measured distant to the battery 2. The diagram in Figure 4 illustrates an actual battery voltage over a measured PCB temperature of a charging unit 1, which is coupled to the battery 2. The graph illustrated in Figure 4 shows, that when a temperature of 40 °C, which might be the threshold temperature, is measured on the PCB 11, the actual battery temperature might still be well below 30 °C. The dependency between the battery temperature and the temperature measured distant to the battery 2, may be determined by getting a certain number of samples. For example, more than 10 samples may be taken, as is illustrated in Figure 4. However, this is only an example. Any number of samples may be taken. When the dependency of the two temperatures is known, this dependency may be expressed by an appropriate formula. In the current case, the formula for estimating the battery temperature may be a polynomial regression model of the form

$$f(x) = a_0 + a_1 * x + a_2 * x^2 + a_3 * x^3 + \ldots \qquad (1).$$

Wherein x is the measured temperature, f(x) is the battery temperature and a0, a1, a2,... are coefficients of the polynomial regression model. If a polynomial regression model of the first degree is used, such as

$$f(x) = mx + b \qquad (2),$$

m might represent the slope of the graph as illustrated in Figure 4 and b might represent the corresponding intercept of the graph.

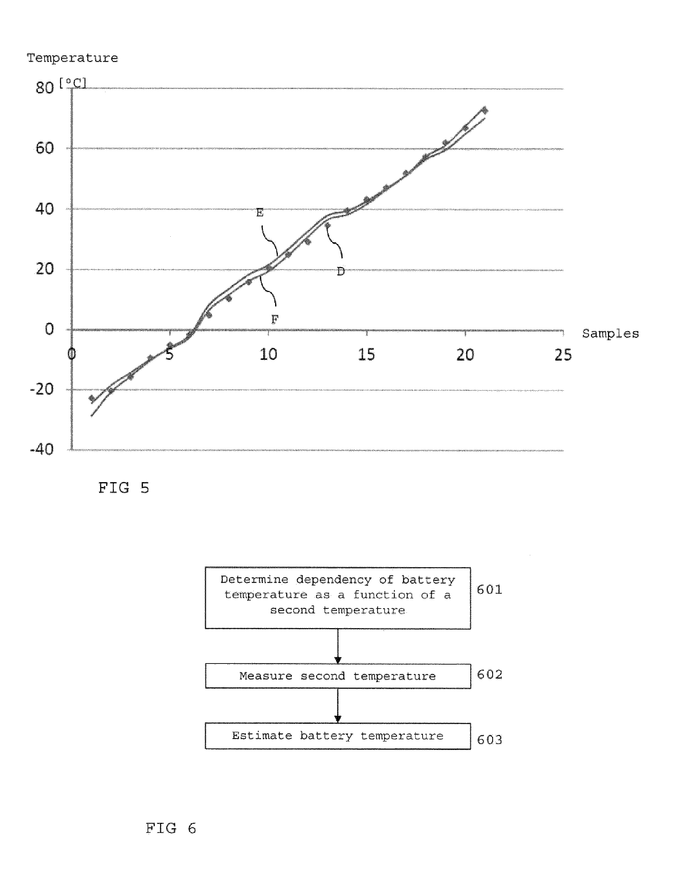

The coefficients of the polynomial regression model can easily be obtained by means of a conventional simulation or technical computing tool, such as Matlab function polyfit, for example. The higher the degree of the polynomial regression model, the more accurate the estimated value of the battery temperature. This is illustrated by means of the diagram in Figure 5. The diagram in Figure 5 shows in a first graph D (dotted line) the actual battery temperature. A second graph E shows the estimated temperature when using a linear regression model and a third graph F shows the estimated temperature when using a polynomial regression model of the second degree. It can clearly be seen, that the estimation using the second degree polynomial regression model delivers more accurate results than the estimation using the linear regression model.

Using a polynomial regression model, however, is only an example. Any other models may be used as well, which are able to deliver accurate results for the estimated battery temperature.

An example of a method for estimating a battery temperature according to the present invention is illustrated in Figure 6. First, a dependency of the battery temperature as a function of a second temperature is determined (step 601). The second temperature is a temperature, which is measured distant to the battery 2. Distant to the battery 2 in this context means that a temperature sensor which is used to measure the second temperature is not in direct contact with the battery 2. Therefore, the second temperature is the temperature of other components coupled to the battery (e.g. the charging unit) or an ambient temperature. A dependency of the battery temperature as a function of the second temperature may, for example, be determined by first determining at least two pairs of values. One pair of values includes a battery temperature and a corresponding second temperature. After determining at least two pairs of values, the dependency may be modeled using a regression method, for example. The dependency may be modeled using a polynomial regression model, for example. A polynomial regression generally is a form of linear regression in which the relationship between an independent variable and a dependent variable is modeled as an nth degree polynomial. The coefficients in the regression method may be determined using a simulation tool, for example. Several simulation tools are known in the art and will not be explained in further detail herein. Once the dependency of the battery temperature as a function of the second temperature is known, the second temperature may be measured (step 602) and the corresponding battery temperature may be estimated according to the given dependency (step 603).

For example, the estimation of the battery temperature may be performed by the controller 121. The controller 121, however, does not necessarily need to be included in the charging unit 1. The controller 121 may instead be included in any other module which is arranged close to the battery 2 and preferably coupled to the battery 2.

The temperature estimation may be implemented in software, for example. Usually, temperature sensors are already provided within a charging unit 1 for monitoring a temperature of the unit. So in many cases no additional temperature sensors will be needed for a battery temperature estimation.

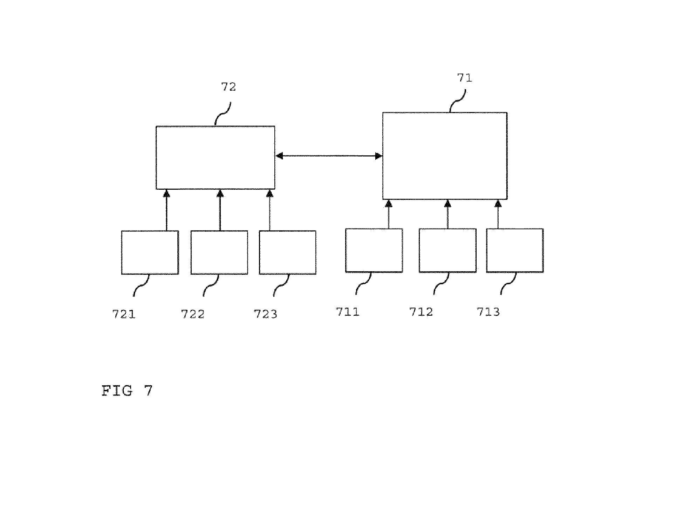

One embodiment of a software module implementation of the current method is illustrated by means of Figure 7. The components illustrated in Figure 7 may be the system's classes. The components, or classes, may have different attributes. A processing module 71 (DeltaComputer) may receive different parameters from a delta module 711 (Delta-Parameters) and a parameter module 712 (AccumulatorParameters). The processing module 71 may implement the algorithms for computing the battery voltage and temperature. The real battery voltage may be different from the actually measured voltage. The processing module 71 may consider a dynamic delta voltage which is added to the measured voltage to obtain a virtual battery voltage. The virtual battery voltage represents a result of the battery temperature, ageing of the battery and charging coefficients summed with the measured battery voltage. The dynamic delta voltage may be measured at predefined time instances.

The parameter module 712 may, for example, contain parameters such as the battery voltage and the battery temperature. It may further contain a terminal 30 (vehicle battery supply) status, e.g. connected or not connected. Based on the current parameters as well as on previous parameters, a terminal 30 transition can be detected. A terminal 30 transition may trigger a determination of a new delta voltage.

The delta module 711 contains the most recent delta parameters which are used for computing the dynamic delta voltage, which is required for computing the virtual voltage. The delta module 711 represents a data container which encapsulates different parameters. A temperature module 713 includes a delta buffer which contains temperature pairs (measured temperature - real temperature). Such temperature pairs may be recorded for temperatures below 0 °C (low temperatures), for temperatures between 0 °C and 35 °C (medium temperatures) and for temperatures above 35 °C (high temperatures).

Different methods may be performed by the software module. A first method getVirtualVoltage may return a current virtual voltage and may compute new delta parameters when a transition of terminal 30 is detected. A second method init may initialize the internal variable with different values. The delta buffers and delta parameters may be extracted. A third method resume may reset filtering counters and may deactivate a battery voltage filtering. A fourth method computeVirtualVoltage may be used internally only to compute the virtual voltage. The virtual voltage may be equal to the real voltage if the terminal 30 status is ON (vehicle battery connected). The virtual voltage may be equal to the difference between the real voltage and the dynamically computed delta voltage if the terminal 30 status is OFF (vehicle battery not connected). A fifth method computeDeltaFunction may be used internally to compute the dynamic delta voltage as a function of the battery temperature. Depending on the battery temperature, one of three sections of this function is selected. A first section may be constant, a second section may be linear and a third section may be exponential. The function may be calculated using the delta parameters and the battery temperature.

A sixth method verifyValueInRange may be a Boolean method which is used internally to verify if a value is within specified ranges. A seventh method verifyVoltageVariation may be an internal Boolean method which verifies if both the battery voltage and the voltage variation are valid. Firstly, the voltage should be in specified ranges. Secondly, the battery voltage level should be consistent with the terminal 30 status. This may be assured by verifying that significant variations between two voltage levels appear only when a transition of terminal 30 happens. An eight method verifyDeltaVariation may be an internal Boolean method which verifies if a new measured delta voltage is in specified ranges. For computing the thresholds it uses as a reference value the computed dynamic delta voltage, using the former delta parameters and the current battery temperature.

A ninth method verifyTerm30Transition may be an internal Boolean method which is used to detect a terminal 30 transition. The transition represents a change of status (ON->OFF or OFF->ON). A tenth method updateDeltaParameters may be used internally to update the delta parameters when a new delta voltage is measured at a terminal 30 transition. It adds the new delta voltage pair to the corresponding delta buffer and computes the new delta parameters. An eleventh method addElementInTheEnd may be an internal method which adds a new element in a delta buffer. If the current size exceeds the maximum length, the values are shifted to the left. In this way, only the most recent delta pairs are retained.

A twelfth method computeNewDeltaParameters may be an internal method which computes the delta parameters using delta temperature pairs from each delta buffer. It uses the arithmetical mean for the constant section and the so-called Linear Least Squares algorithm for computing the parameters for the linear and exponential sections of the function. A thirteenth method extractDeltaParameters may be an internal method for extracting the delta parameters from the configuration. A fourteenth method extractDeltaTemperaturePairs maybe an internal method which extracts the delta temperature pairs for a specified delta buffer.

Further methods perform the storing of the delta parameters and the delta buffers when new values are computed, the storing of the delta parameters and the storing of the elements of a delta buffer.

A peripheral module 723 (ComponentPeripheralDriver) may provide a battery voltage and a battery temperature to a voltage module 72 (AccumulatorVoltageDaemon). A driver module 722 may provide the terminal 30 status to the voltage module 72. Further, peripheral package 721 may be connected to the voltage module 72.

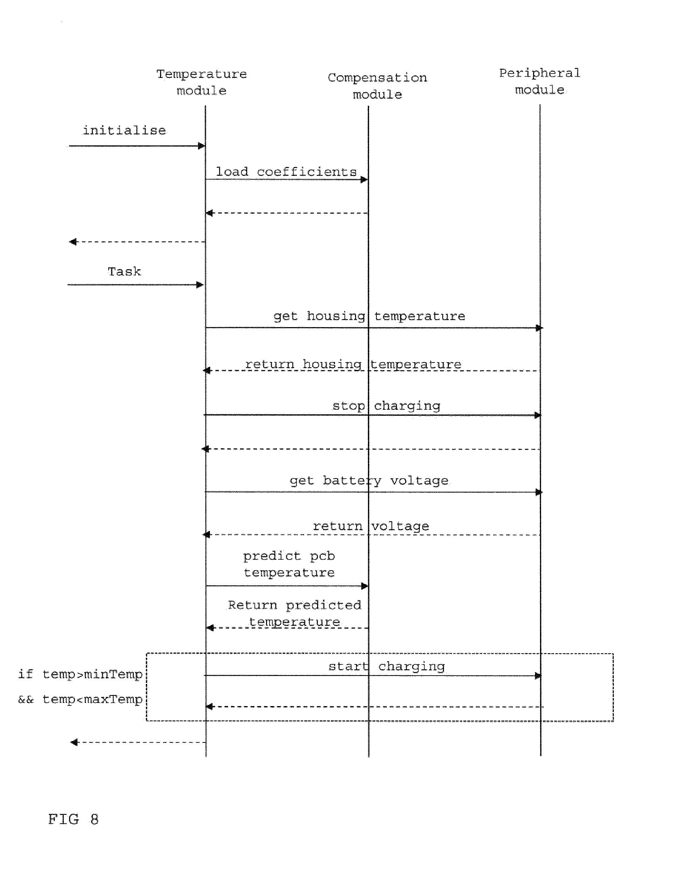

In the sequence diagram in Figure 8 the interaction of the objects in a software module implementation according to Figure 7 is illustrated. When the voltage module 72 is initiated, it loads the determined regression coefficients (a0, a1, a2,...) into the compensation module 721. The voltage module 72 then gets the housing temperature (or PCB temperature or any other temperature measured distant to the battery) from the peripheral module 722. Charging of the battery is stopped and a battery voltage is determined by the peripheral module 722 and provided to the voltage module 72. The voltage module 72 then instructs the compensation module 721 to estimate the battery temperature. The compensation module 721 returns the estimated battery temperature to the voltage module 72. If the estimated battery temperature is higher than a first threshold temperature and lower than a second threshold temperature, charging of the battery will continue. Otherwise the charging will be stopped until the estimation provides a battery temperature, which satisfies the given conditions.

List of reference numbers

**[0041]**

| 1 | charging unit |
| 11 | printed circuit board |
| 121 | controller |
| 122 | temperature sensor |
| 13 | temperature sensor |
| 2 | battery |
| 71 | processing module |
| 711 | delta module |
| 712 | parameter module |
| 713 | temperature module |
| 72 | voltage module |
| 721 | peripheral package |
| 722 | driver module |
| 723 | peripheral module |

**Claims**

1. Method for determining the temperature of a battery (2), the method comprises:

   determining a dependency of the battery temperature as a function of a second temperature, wherein the second temperature is a temperature distant to the battery (2);
   measuring the second temperature; and
   estimating the temperature of the battery (2) according to the determined dependency.

2. Method according to claim 1, wherein the dependency of the battery temperature as a function of the second temperature is determined by determining at least two pairs of values, each pair of values comprising a battery temperature and a corresponding second temperature.

3. Method according to claim 2, wherein determining the dependency of the battery temperature as a function of the second temperature further comprises modeling the dependency, using a regression method.

4. Method according to claim 3, wherein the dependency of the battery temperature as a function of the second temperature is modeled using a polynomial regression model.

5. Method according to any of the preceding claims,
   wherein the second temperature is a temperature of a charging unit (1), which is coupled to the battery (2) and which is configured to charge the battery (2).

6. Method according to claim 5, wherein the second temperature is an ambient temperature within the charging unit (1).

7. Method according to claim 5, wherein the second temperature is a temperature measured on a printed circuit board (11) of the charging unit (1).

8. Method according to any of the preceding claims, further comprising
   stop or prevent charging the battery (2), if the estimated battery temperature is below a first temperature threshold or above a second temperature threshold.

9. Method according to claim 8, wherein the first temperature threshold is 0 °C and the second temperature threshold is 40 °C.

**10.** System for estimating the temperature of a battery (2), the system comprising
a temperature sensor (122, 13), configured to measure a second temperature, wherein the second temperature is a temperature distant to the battery (2);
a controller (121), configured to estimate the temperature of the battery (2) according to a predetermined dependency of the battery temperature as a function of the second temperature.

**11.** System according to claim 10, wherein the battery (1) is a lithium-ion battery.

**12.** System according to claim 10 or 11, further comprising a charging unit (1) which is coupled to the battery (2) and which is configured to charge the battery (2).

**13.** System according to any of claims 10 to 12, wherein the temperature sensor (122) is coupled to a printed circuit board (11) within the charging unit (1), and wherein the temperature sensor (122) is configured to measure the temperature of the printed circuit board (11).

**14.** System according to any of claims 10 to 12, wherein the temperature sensor (13) is coupled to a housing of the charging unit (1), and wherein the temperature sensor (13) is configured to measure an ambient temperature within the charging unit (1).

FIG 1

FIG 2

Temperature

FIG 3

Battery

temperature

FIG 4

Temperature

$80 \, [°C]$

FIG 5

FIG 6

FIG 7

FIG 8

Europäisches
Patentamt

European
Patent Office

Office européen
des brevets

## EUROPEAN SEARCH REPORT

**Application Number**

EP 15 46 5548

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/150369 A1 (DENIAU JEAN-CHRISTOPHE [US]) 5 August 2004 (2004-08-05) * figures 1,2 * * paragraphs [0004], [0011] - [0013], [0020] - [0022] * | 1-4,10, 11 | INV. H01M10/44 G01R31/36 H01M10/46 H01M10/48 H02J7/00 |
| X | DE 10 2011 087747 A1 (CONTINENTAL AUTOMOTIVE GMBH [DE]) 6 June 2013 (2013-06-06) * paragraphs [0004] - [0006], [0040], [0043] - [0046] * * claim 1 * * figures 1,2 * | 1,5-14 | ADD. B60L11/18 |
| X | US 2007/139017 A1 (MARCHAND DAVID G [US] ET AL) 21 June 2007 (2007-06-21) * figures 1-3 * * claim 1 * | 1,10 | |
| A | DE 10 2011 004353 A1 (CONTINENTAL AUTOMOTIVE GMBH [DE]) 23 August 2012 (2012-08-23) * paragraphs [0002], [0008], [0009], [0034] - [0036], [0040] * * claim 1 * * figures 1-4 * | 1-14 | |

| TECHNICAL FIELDS SEARCHED (IPC) |
|---|
| H01M H02J B60L G01R |

The present search report has been drawn up for all claims

| Place of search | Date of completion of the search | Examiner |
|---|---|---|
| The Hague | 23 March 2016 | Knoflacher, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 46 5548

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2016

| Patent document cited in search report | Publication date | Patent family member(s) | | Publication date |
|---|---|---|---|---|
| US 2004150369 A1 | 05-08-2004 | EP | 1588496 A1 | 26-10-2005 |
| | | JP | 4339799 B2 | 07-10-2009 |
| | | JP | 2006517748 A | 27-07-2006 |
| | | US | 2004150369 A1 | 05-08-2004 |
| | | WO | 2004070960 A1 | 19-08-2004 |
| DE 102011087747 A1 | 06-06-2013 | DE | 102011087747 A1 | 06-06-2013 |
| | | WO | 2013083491 A1 | 13-06-2013 |
| US 2007139017 A1 | 21-06-2007 | US | 2007139017 A1 | 21-06-2007 |
| | | WO | 2007073452 A1 | 28-06-2007 |
| DE 102011004353 A1 | 23-08-2012 | NONE | | |

EPO FORM P0459

For more details about this annex : see Official Journal of the European Patent Office, No. 12/82